# EUROPEAN PATENT SPECIFICATION

(11) **EP 3 044 260 B1**
(45) Date of publication and mention of the grant of the patent: **05.09.2018**
(21) Application number: 13893592.9
(22) Date of filing: 11.09.2013
(51) Int. Cl.: C08L 21/00

(54) **MULTI-PHASE ELASTOMERIC THERMALLY CONDUCTIVE MATERIALS**
MEHRPHASIGE ELASTOMERE WÄRMELEITFÄHIGE MATERIALIEN
MATÉRIAUX ÉLASTOMÈRES À PLUSIEURS PHASES THERMIQUEMENT CONDUCTEURS

(43) Date of publication of application: 20.07.2016
(73) Proprietor: Dow Global Technologies LLC, Midland, MI 48674 (US)
(72) Inventor: YANG, Yunfeng, Hangzhou Zhejiang 310027 (CN); CHEN, Hongyu, Shanghai 201203 (CN); ESSEGHIR, Mohamed, Lawrenceville, New Jersey 08648 (US); CHAUDHARY, Bharat I., Princeton, New Jersey 08540 (US)
(74) Representative: Boult Wade Tennant LLP
(86) International application number: PCT/CN2013/083328
(87) International publication number: WO 2015/035575

(56) References cited:
- WO-A1-03/028039
- CN-A- 103 160 172
- JP-A- 2006 089 579
- JP-A- 2012 211 250
- US-A1- 2006 062 597
- US-A1- 2011 242 764

## Description

### FIELD

Various embodiments of the present invention relate to thermally conductive materials comprising a non-polar elastomer, a polar elastomer, and a thermally conductive filler.

### INTRODUCTION

With increasing need to dissipate heat from microelectronic devices, the role of thermal interface materials ("TIM"s) is becoming increasingly important to the overall performance of the device package. Two key needs for TIMs are higher thermal conductivity and lower interfacial thermal resistance. Thermally conductive (electrically insulating or electrically conductive) fillers can be added into a TIM matrix (mainly polymers) to increase their thermal conductivity. However, a high volume percent of filler is usually needed to form a continuous filler network to achieve high thermal conductivity in the TIM. This can be problematic, however, because a high volume fraction of inorganic fillers tends to negatively affect other properties of the TIM, such as softness, flexibility, and conformability to surface, while simultaneously increasing cost due to the high price of thermally conductive fillers. It would therefore be desirable to produce a TIM with less filler while maintaining sufficient thermal conductivity.

### SUMMARY

One embodiment is a thermally conductive material, comprising:
(a) a non-polar elastomer;
(b) a polar elastomer; and
(c) a thermally conductive filler,
wherein said non-polar elastomer and said polar elastomer are sufficiently immiscible to be present as a multi-phase system having a non-polar elastomer phase and a polar elastomer phase,
wherein at least 60 volume percent ("vol%") of said thermally conductive filler is located in one of said non-polar elastomer phase or said polar elastomer phase,
wherein said thermally conductive material has a tensile modulus of less than 200 megapascals ("MPa").

Another embodiment is a method for preparing a thermally conductive material, said method comprising:
(a) combining a thermally conductive filler with a first elastomer thereby forming a filler-containing masterbatch; and
(b) combining said filler-containing masterbatch with a second elastomer thereby forming said thermally conductive material,
wherein said first elastomer and said second elastomer are sufficiently immiscible to be present in said thermally conductive material as a multi-phase system having a first elastomer phase formed by at least a portion of said first elastomer and a second elastomer phase formed by at least a portion of said second elastomer,
wherein at least 60 volume percent ("vol%") of said thermally conductive filler remains located in said first elastomer phase following said combining of step (b),
wherein one of said first and second elastomers is a non-polar elastomer, wherein the other of said first and second elastomers is a polar elastomer,
wherein said thermally conductive material has a tensile modulus of less than 200 megapascals ("MPa").

### BRIEF DESCRIPTION OF THE DRAWINGS

Reference is made to the accompanying drawings in which:
FIG. 1(a) is a scanning electron micrograph of a sample, S1, prepared according to one embodiment of the present invention with a magnification of 500x;
FIG. 1(b) is the same scanning electron micrograph as FIG. 1(a) but with a magnification of 2,000x;
FIG. 2(a) is a scanning electron micrograph of a sample, S2, prepared according to one embodiment of the present invention with a magnification of 1,000x;
FIG. 2(b) is the same scanning electron micrograph as FIG. 2(a) but with a magnification of 3,000x;
FIG. 3(a) is a scanning electron micrograph of a sample, S3, prepared according to one embodiment of the present invention with a magnification of 500x;
FIG. 3(b) is the same scanning electron micrograph as FIG. 3(a) but with a magnification of 1,000x;
FIG. 4(a) is a scanning electron micrograph of a sample, S4, prepared according to one embodiment of the present invention with a magnification of 1,000x;
FIG. 4(b) is the same scanning electron micrograph as FIG. 4(a) but with a magnification of 5,000x;
FIG. 5(a) is a scanning electron micrograph of a sample, S5, prepared according to one embodiment of the present invention with a magnification of 500x;
FIG. 5(b) is the same scanning electron micrograph as FIG. 5(a) but with a magnification of 1,000x;
FIG. 6(a) is a scanning electron micrograph of a sample, S6, prepared according to one embodiment of the present invention with a magnification of 2,000x;
FIG. 6(b) is the same scanning electron micrograph as FIG. 6(a) but with a magnification of 5,000x;
FIG. 7 is a scanning electron micrograph of a comparative sample, CS2, with a magnification of 1,000x.

### DETAILED DESCRIPTION

Various embodiments of the present invention concern a thermally conductive material comprising (a) a non-polar elastomer, (b) a polar elastomer, and (c) a thermally conductive filler. Additionally, certain embodiments concern methods for preparing such thermally conductive materials as well as articles of manufacture employing such thermally conductive materials as thermal interface materials.

### Non-polar Elastomer

As noted above, one component of the thermally conductive materials described herein is a non-polar elastomer. As used herein, the term "elastomer" denotes a polymer having viscoelasticity. Generally, elastomers will have lower tensile modulus and higher failure strain relative to other materials, such as thermoplastics. As used herein, the term "non-polar" denotes a polymer containing no polar bonds between carbon atoms and other atoms having relatively high electronegativity (such as O, N, F, Cl) or, if such polar bonds are present, a polymer in which there is no net dipole because of the symmetrical arrangement of such polar bonds. "Polymer" means a macromolecular compound prepared by reacting (i.e., polymerizing) monomers of the same or different type. "Polymer" includes homopolymers and interpolymers. "Interpolymer" means a polymer prepared by the polymerization of at least two different monomer types. This generic term includes copolymers (usually employed to refer to polymers prepared from two different monomer types), and polymers prepared from more than two different monomer types (e.g., terpolymers (three different monomer types) and tetrapolymers (four different monomer types)).

Non-polar elastomers suitable for use herein can have a melting point of less than 90 °C, less than 85 °C, less than 80 °C, less than 75 °C, or less than 70 °C. In various embodiments, the non-polar elastomer can have a melting point of at least 40 °C. The melting point of polymers is determined according to the procedure described in the Test Methods section, below.

The non-polar elastomers suitable for use herein can have a Shore A hardness of less than 100, less than 90, or less than 80. In various embodiments, the non-polar elastomer can have a Shore A hardness of at least 40, at least 50, or at least 60. Furthermore, the non-polar elastomers suitable for use herein can have a Shore D hardness of less than 50, less than 40, or less than 30. In various embodiments, the non-polar elastomer can have a Shore D hardness of at least 5, at least 10, or at least 13. Shore A and D hardness are determined according to ASTM International ("ASTM") method D2240.

The non-polar elastomers suitable for use herein can have a tensile modulus (automatic Young's) of less than 100 MPa, less than 75 MPa, less than 50 MPa, or less than 25 MPa. In various embodiments, the non-polar elastomers can have a tensile modulus greater than zero. Tensile modulus is determined according to ASTM method D638.

The non-polar elastomers suitable for use herein can have a melt index (I₂) in the range of from 1 to 30 grams per ten minutes ("g/10 min."), from 2 to 20 g/10 min., or from 3 to 17 g/10 min. Melt indices provided herein are determined according to ASTM method D1238. Unless otherwise noted, melt indices are determined at 190 °C and 2.16 Kg (i.e., I₂).

The non-polar elastomers suitable for use herein can have a density in the range of from 0.850 to 0.920 grams per cubic centimeter ("g/cm³"), from 0.860 to 0.910 g/cm³, or from 0.864 to 0.902 g/cm³. Polymer densities provided herein are determined according to ASTM method D792.

The type of elastomer suitable for use as the non-polar elastomer can be selected from any conventional or hereafter discovered elastomer having one or more of the desired properties. Examples of such non-polar elastomers include, but are not limited to, polyolefin elastomers, ethylene-propylene-diene monomer ("EPDM") rubbers, and styrenic block copolymers, such as styrene-butadiene-styrene ("SBS"), styrene-isoprene-styrene ("SIS"), styrene-ethylene/propylene-styrene ("SEPS"), and styrene-ethylene/butylene-styrene ("SEBS").

In various embodiments, the non-polar elastomer can be a polyolefin elastomer. Polyolefin elastomers are generally thermoplastic elastomers. As known in the art, thermoplastic elastomers are polymers having characteristics of both thermoplastic polymers and elastomeric polymers. A "polyolefin elastomer" denotes a thermoplastic elastomer interpolymer prepared from two or more types of α-olefin monomers, including ethylene monomers. In general, polyolefin elastomers can be substantially linear and can have a substantially homogeneous distribution of comonomer.

In various embodiments, the polyolefin elastomer is prepared from ethylene and one or more additional types of α-olefin comonomers. In one or more embodiments, the polyolefin elastomer is a copolymer of ethylene and an α-olefin comonomer. The α-olefin monomers suitable for use in the polyolefin elastomers include ethylene and any C₃₋₂₀ (i.e., having 3 to 20 carbon atoms) linear, branched, or cyclic α-olefin. Examples of C₃₋₂₀ α-olefins include propene, 1-butene, 4-methyl-1-pentene, 1-hexene, 1-octene, 1-decene, 1-dodecene, 1-tetradecene, 1-hexadecene, and 1-octadecene. The α-olefins can also have a cyclic structure such as cyclohexane or cyclopentane, resulting in an α-olefin such as 3-cyclohexyl-1-propene (allyl cyclohexane) and vinyl cyclohexane. In various embodiments, the polyolefin elastomer is a copolymer of ethylene/α-butene, ethylene/α-hexene, ethylene/α-octene, or combinations of two or more thereof.

In one embodiment, the polyolefin elastomer is a homogeneously branched linear ethylene/α-olefin copolymer or a homogeneously branched, substantially linear ethylene/α-olefin copolymer. In a further embodiment, the α-olefin is selected from propylene, 1-butene, 1-hexene, or 1-octene, and preferably from 1-butene, 1-hexene or 1-octene, and more preferably from 1-octene or 1-butene. In an embodiment, the polyolefin elastomer is a copolymer of ethylene/α-octene.

In various embodiments, the non-polar elastomer can be a combination of two or more polyolefin elastomers. For example, a non-polar elastomer having one or more properties outside a desired range may be combined with a second non-polar elastomer so that the blend of the two non-polar elastomers has the desired properties.

Production processes used for preparing polyolefin elastomers are wide, varied, and known in the art. Any conventional or hereafter discovered production process for producing polyolefin elastomers having the properties described above may be employed for preparing the polyolefin elastomers described herein.

Commercial examples of polyolefin elastomers suitable for use herein include ENGAGE™ polyolefin elastomers (e.g., ENGAGE™ 8130, 8200, 8402, or 8452 polyolefin elastomers) and AFFINITY™ polyolefin elastomers (e.g., AFFINITY™ GA 1875, 1900, 1000R, 1950), available from The Dow Chemical Company, Midland, MI, USA. Other commercial examples of polyolefin elastomers suitable for use herein include EXACT™ plastomers available from ExxonMobil Chemical, Houston, TX, USA, and TAFMER™ α-olefin copolymers available from Mitsui Chemicals Group, Tokyo, Japan.

In one or more embodiments, the non-polar elastomer can be present in the thermally conductive material in an amount ranging from 15 to 60 volume percent ("vol%"), preferably from 25 to 50 vol%, based on the total volume of the non-polar elastomer, the polar elastomer, and the thermally conductive filler.

### Polar Elastomer

As noted above, another component of the thermally conductive materials described herein is a polar elastomer. As used herein, the term "polar" denotes a polymer having a net dipole as the result of opposing charges (i.e. having partial positive and partial negative charges) from polar bonds arranged asymmetrically. Polar bonds in the polar elastomer are bonds between carbon atoms and other atoms having relatively high electronegativity, such as O, N, F, and Cl. In various embodiments, the content of polar moieties containing such polar bonds can be at least 10 wt% based on the total weight of the polar elastomer.

Polar elastomers suitable for use herein can have a melting point of less than 90 °C, less than 85 °C, less than 80 °C, less than 75 °C, or less than 70 °C. In various embodiments, the polar elastomer can have a melting point of at least 40 °C.

The polar elastomers suitable for use herein can have a Shore A hardness of less than 100, less than 95, or less than 90. In various embodiments, the polar elastomer can have a Shore A hardness of at least 30, at least 40, or at least 50. Furthermore, the polar elastomers suitable for use herein can have a Shore D hardness of less than 60, less than 50, or less than 40. In various embodiments, the polar elastomer can have a Shore D hardness of at least 6, at least 10, or at least 12.

The polar elastomers suitable for use herein can have a tensile modulus (automatic Young's) of less than 100 MPa, less than 75 MPa, less than 50 MPa, or less than 25 MPa. In various embodiments, the polar elastomers can have a tensile modulus of greater than zero.

The polar elastomers suitable for use herein can have a melt index (I₂) in the range of from 5 to 1,000 g/10 min., from 10 to 900 g/10 min., or from 20 to 800 g/10 min.

The polar elastomers suitable for use herein can have a density in the range of from 0.900 to 1.250 g/cm³, from 0.930 to 1.200 g/cm³, or from 0.950 to 1.100 g/cm³.

The type of elastomer suitable for use as the polar elastomer can be selected from any conventional or hereafter discovered elastomers having one or more of the desired properties. In one or more embodiments, the polar elastomer can be a thermoplastic elastomer. Examples of suitable polar elastomers include, but are not limited to, ethylene-vinyl acetate copolymers ("EVA"), polyurethane rubbers, thermoplastic polyurethanes ("TPU"), ethylene acrylate copolymers (e.g., ethylene-methyl acrylate copolymers, ethylene-ethyl acrylate copolymers, and the like), and ethylene acrylic acid copolymers. In an embodiment, the polar elastomer is selected from a TPU and an EVA.

Polar elastomers containing polar functional groups and/or polar comonomers can comprise such polar functional groups / polar comonomers in a total amount of at least 20, at least 25, or at least 30 mole percent ("mol%"). Additionally, polar elastomers containing polar functional groups and/or polar comonomers can comprise such polar functional groups / polar comonomers in a total amount ranging from 20 to 40 mol%, or from 25 to 35 mol%. For example, when an EVA is employed as the polar elastomer, such EVA can have a vinyl acetate content ranging from 20 to 40 mol%, or from 25 to 35 mol%.

Production processes used for preparing polar elastomers are wide, varied, and known in the art. Any conventional or hereafter discovered production process for producing polar elastomers having the desired properties may be employed for preparing the polar elastomers described herein.

Commercial examples of polar elastomers suitable for use herein include, but are not limited to, ELVAX™ EVA 150w or 250, available from E.I. du Pont de Nemours and Company, Wilmington, DE, USA; EVATANE™ EVA 28-800, available from Arkema S.A., Colombes, France; AMPLIFY™ and PRIMACOR™ functional polymers, available from The Dow Chemical Company, Midland, MI, USA; MILLATHANE™ millable polyurethane rubbers, available from TSE Industries, Inc., Clearwater, FL, USA; and ESTANE™ MVT 70AT3, available from Lubrizol Advanced Materials, Inc., Cleveland, OH, USA.

In one or more embodiments, the polar elastomer can be present in the thermally conductive material in an amount ranging from 15 to 45 volume percent vol%, preferably from 20 to 40 vol%, based on the total volume of the non-polar elastomer, the polar elastomer, and the thermally conductive filler.

### Thermally Conductive Filler

The thermally conductive filler suitable for use herein can have a thermal conductivity of at least 25 watts per meter Kelvin ("W/m·K"). In various embodiments, the thermally conductive filler has a thermal conductivity ranging from 25 to 1,700 W/m·K, or from 30 to 500 W/m·K. Additionally, the thermally conductive filler can be either electrically conductive or electrically insulating.

Fillers suitable for use herein can have any conventional or hereafter discovered shape, particle size, and density. In various embodiments, the filler can have a shape selected from particulates (such as granules or powder), fibers, platelets, spheres, needles, or any combination thereof. Additionally, when a particulate filler is employed, the filler can have an average particle size (d_{50%}) of at least 0.01 micrometer ("µm"), at least 0.1 µm, at least 1 µm, or at least 2 µm. Further, the filler can have an average particle size in the range of from 0.01 to 50 µm, from 0.1 to 25 µm, from 1 to 10 µm, or from 2 to 7 µm.

Specific examples of fillers suitable for use herein include, but are not limited to, aluminum oxide (Al₂O₃), magnesium oxide (MgO), boron nitride (BN), zinc oxide (ZnO), silicon carbide (SiC), aluminum nitride (AlN), graphite, expanded graphite, multi-walled carbon nanotubes, carbon fiber, pyrolytic graphite sheets, silver, aluminum, copper, and mixtures of two or more thereof.

In one or more embodiments, the thermally conductive filler can be present in the thermally conductive material in an amount ranging from 20 to 60 vol%, preferably from 35 to 60 vol%, based on the total volume of the non-polar elastomer, the polar elastomer, and the thermally conductive filler.

### Additives

Optional additives for use in the thermally conductive material include, but are not limited to, waxes, oils, tackifiers, antioxidants (e.g., IRGANOX™ 1010), coupling agents (e.g., silane-based or titanate-based coupling agents), thermal stabilizers, processing aids, and flame retardants. Such additives can be employed in any desired amount to achieve their desired effect. Typically, such additives can be present in the thermally conductive material in an amount ranging from 0.1 wt% to 5 wt% based on the total weight of non-polar elastomer and polar elastomer for waxes, oils, tackifiers, antioxidants, thermal stabilizers, processing aids; from 0.5 wt% to 3 wt% based on the total weight of filler for coupling agents; and from 20 wt% to 60 wt% based on the total weight of non-polar elastomer and polar elastomer for flame retardants.

### Thermally Conductive Material

In an embodiment, the thermally conductive material is prepared by first melt-mixing the thermally conductive filler in either the non-polar elastomer or the polar elastomer to make a filler-containing masterbatch. The filler loading in the masterbatch phase can be in the range of from 30 to 90 vol%, or from 40 to 85 vol%, or from 60 to 80 vol%. Melt mixing of the filler and one of the elastomer components can be achieved by any conventional or hereafter discovered melt-mixing procedures. For example, melt extrusion or mixing in a HAAKE melt mixer may be employed. Once the filler-containing masterbatch has been prepared, it can then be melt-mixed with the remaining elastomer component using any melt-mixing methods. Additives, if employed, can be melt-mixed at any time, either in the masterbatch phase, the non-masterbatch phase, or the combined material.

In various embodiments, the non-polar elastomer and the polar elastomer are sufficiently immiscible to be present as a multi-phase system having a non-polar elastomer phase and a polar elastomer phase. As used herein, the term "immiscible" means phase-separated for the original polymers in one polymer blend. The criterion of immiscible polymer blends is that *ΔGₘ* = *ΔHₘ - TΔSₘ* > 0, where *ΔGₘ* is Gibbs' free energy of mixing, *ΔHₘ* is heat of mixing and *ΔSₘ* is the statistical entropy of mixing. If such a blend is made of two polymers, two glass transition temperatures will be observed. Such immiscibility between the non-polar elastomer and polar elastomer should be observed up to a temperature of at least 200 °C.

Following combination of all components, at least 60 vol%, at least 65 vol%, at least 70 vol%, at least 75 vol%, or at least 80 vol% of the thermally conductive filler remains located in the masterbatch phase of the thermally conductive material. In various embodiments, the masterbatch phase of the thermally conductive material can contain in the range of from 60 to 99 vol% of the thermally conductive filler, in the range of from 70 to 99 vol% of the thermally conductive filler, or in the range of from 80 to 98 vol% of the thermally conductive filler. Determination of filler location in the thermally conductive material is performed according to the procedure described in the Test Methods section, below.

In various embodiments, the polar elastomer is employed as the elastomer used to prepare the filler-containing masterbatch. Accordingly, in one or more embodiments, the polar elastomer phase can contain at least 60 vol%, at least 65 vol%, at least 70 vol%, at least 75 vol%, or at least 80 vol% of the thermally conductive filler. Furthermore, in various embodiments, the polar elastomer can contain in the range of from 60 to 99 vol% of the thermally conductive filler, in the range of from 70 to 99 vol% of the thermally conductive filler, or in the range of from 80 to 98 vol% of the thermally conductive filler.

In various embodiments, the filler-containing masterbatch forms a continuous phase within the thermally conductive material. The term "continuous phase" is an art-recognized term meaning a component that disperses other components in a disperse system, also called sea phase (versus island phase). A continuous phase of the filler-containing masterbatch can be achieved in the thermally conductive material by, for example, adjusting the volume ratio of the filler-containing elastomer masterbatch and the other elastomer according to their viscosity ratio. Generally, there are two approaches to making the filler-containing masterbatch be continuous, (1) increase volume ratio of the filler-containing masterbatch and the other elastomer, i.e. mainly increase the volume fraction of the filler-containing masterbatch; (2) decrease the viscosity ratio of the filler-containing masterbatch and the other elastomer. In one or more embodiments, the filler-containing masterbatch and the other elastomer can form a co-continuous system where each of the filler containing masterbatch and the other elastomer form continuous phases within the thermally conductive material.

The resulting thermally conductive material can have a melting point of less than 90 °C, less than 85 °C, less than 80 °C, less than 75 °C, or less than 70 °C. In various embodiments, the thermally conductive material can have a melting point of at least 50 °C.

In various embodiments, the thermally conductive material can have a Shore A hardness of less than 100, less than 95, or less than 90. In one or more embodiments, the thermally conductive material can have a Shore A hardness ranging from 60 to 100, or from 68 to 96. The thermally conductive material can have a Shore D hardness of less than 60, less than 55, or less than 50. In one or more embodiments, the thermally conductive material can have a Shore D hardness ranging from 10 to 50, or from 13 to 41.

In various embodiments, the thermally conductive material can have a tensile modulus of less than 200 MPa, less than 150 MPa, or less than 100 MPa. Additionally, the thermally conducive material can have a tensile modulus ranging from 10 to 100 MPa, from 30 to 80 MPa, or from 50 to 75 MPa.

In various embodiments, the thermally conductive material can have a thermal conductivity that is at least 5 %, at least 10 %, or at least 15 % greater than an identical second material except that the second material has a homogenously distributed thermally conductive filler. As used herein, the term "homogenously distributed" denotes a process whereby the filler is divided between each elastomer evenly and melt mixed with each individual elastomer prior to melt mixing the two elastomers. In other words, a filler-containing masterbatch is prepared for both the non-polar elastomer and the polar elastomer; thereafter, the two filler-containing masterbatches are melt mixed together.

### Articles of Manufacture

The above-described thermally conductive material can be employed as a thermal interface material in a variety of articles of manufacture. In various embodiments, the thermally conductive material can be employed in an article of manufacture comprising a heat-generating component, a heat-dissipating component, and a thermal interface material, where the thermal interface material is positioned so as to transfer heat from the heat-generating component to the heat-dissipating component, and where the thermal interface material comprises the above-described thermally conductive material. Examples of heat-generating components include, but are not limited to, microprocessors, central processing units, and graphics processors. An example of a heat-dissipating component includes, but is not limited to, a heat sink.

### TEST METHODS

### Density

Density is determined according to ASTM D792.

### Filler Distribution

Microtome the sample to reveal a cross-section using an Ultramicrotome UC7 (Leica, Germany) equipped with a cryo-chamber. Next, stain the sample using ruthenium (III) chloride, available from Acros Organics. This stain reveals the two different elastomer phases. Coat a thin layer of platinum by spray application on the cross-section of the sample. Perform elemental analysis by scanning electron microscope energy-dispersive X-ray spectroscopy ("SEM EDX") on three randomly selected areas on each of the two polymer phases. The SEM EDX instrument employed is SEM (Nova NanoSEM 630 (FEI, USA)) equipped with an XFlash Detector 5030 (Bruker Nano, USA), which is used to detect the characteristic X-rays. SEM EDX is performed using the following parameters: X-rays are generated by high energy electron beam, and electron accelerating voltage is 15 kV.

It is assumed that platinum is homogenously distributed on each elastomer phase, so platinum can act as an internal reference. Using aluminum as the filler, calculate the aluminum-to-platinum ratio in the filler-containing masterbatch phase as Al/Pt(1) and the aluminum-to-platinum ratio in the non-masterbatch phase as Al/Pt(2). Then the aluminum distribution in the masterbatch phase can be calculated as Al/Pt(1) / [Al/Pt(1) + Al/Pt(2)], and the aluminum distribution in the non-masterbatch phase can be calculated as Al/Pt(2) / [Al/Pt(1) + Al/Pt(2)]. An average of the three sample readings are reported as the filler distribution.

### Melt Index

Melt index, or I₂, is measured in accordance by ASTM D1238, condition 190 °C / 2.16 kg, and is reported in grams eluted per 10 minutes.

### Melting Point

Melting point is determined by differential scanning calorimetry. The measurements are performed on a DSC-Q2000 instrument under nitrogen atmosphere. About 8 mg of sample is used. Apply a dynamic temperature scan from room temperature to 180 °C at a heating rate of 10 °C/minute. Conduct two scans using the same ramp rate, and the phase-change temperature is obtained from the second scan.

### Shore Hardness

Shore hardness (A and D) is determined according to ASTM method D2240.

### Phase Morphology Observation

Trim and polish a sample specimen to an appropriate size via cryo-microtome, and then stain the specimen using ruthenium tetroxide. After repolising, observe the samples by back scattering electron detector using a Nova NanoSEM 630 scanning electron microscope.

### Tensile Modulus

Tensile modulus is determined according to ASTM D638.

### Thermal Conductivity

Determine thermal conductivity of Sample S1 and Comparative Samples CS1(a) and CS1(b) using Hot Disk equipment (TP 2500, transient plane source) and K System (line source probe). This method conforms with ISO 22007-2:2008. Specifically, samples having a size of 50 mm x 50 mm x 1 mm are used. The thermal conductivity of all other Samples is determined using a steady-state heat flow method (DRL-II apparatus, which conforms to ASTM D5470-2006), sample size: diameter 30 mm x 1 mm (thickness).

### Viscosity

The viscosity of the elastomer phases is determined by frequency sweep test using TA Instrument AR2000ex under the following conditions: Geometry: 25-mm parallel plates; Temperature controller: ETC Oven; Frequency sweep: from 0.1 rad/s to 100 rad/s; Strain: 1%, according to modified ASTM D4440-08.

### Volume Resistivity

Determine volume resistivity according to ASTM D257-07 (Instrument: 6517B Electrometer/High Resistance Meter, Keithley Instruments, Inc.).

### MATERIALS

In the Examples detailed below, the following materials are employed:

### Non-Polar Elastomers

ENGAGE™ 8130 is an ethylene/octene polyolefin elastomer having a density of about 0.864 g/cm³, a melting point of about 56 °C, a Shore A hardness of about 60, a Shore D hardness of about 13, and a melt index of about 13 g/10 minutes, and is commercially available from The Dow Chemical Company, Midland, MI, USA.

ENGAGE™ 8200 is an ethylene/octene polyolefin elastomer having a density of about 0.870 g/cm³, a melting point of about 59 °C, a Shore A hardness of about 66, a Shore D hardness of about 17, and a melt index of about 5 g/10 minutes, and is commercially available from The Dow Chemical Company, Midland, MI, USA.

ENGAGE™ 8402 is an ethylene/octene polyolefin elastomer having a density of about 0.902 g/cm³, a melting point of about 98 °C, a Shore A hardness of about 94, a Shore D hardness of about 44, and a melt index of about 30 g/10 minutes, and is commercially available from The Dow Chemical Company, Midland, MI, USA.

ENGAGE™ 8452 is an ethylene/octene polyolefin elastomer having a density of about 0.875 g/cm³, a melting point of about 66 °C, a Shore A hardness of about 74, a Shore D hardness of about 24, and a melt index of about 3 g/10 minutes, and is commercially available from The Dow Chemical Company, Midland, MI, USA.

NORDEL™ IP 3745P is an ethylene-propylene-diene monomer rubber ("EPDM") having a Mooney viscosity, ML1+4 @ 125 °C, of about 45 (ASTM method D1646), an ethylene mass percent of about 70 (ASTM method D3900), an ethylidene norbornene ("ENB") mass percent of about 0.5 (ASTM method D6047), a density of about 0.88 g/cm³, and is commercially available from The Dow Chemical Company, Midland, MI, USA.

NORDEL™ IP 4520 is an EPDM having a Mooney viscosity, ML1+4 @ 125 °C, of about 20 (ASTM method D1646), an ethylene mass percent of about 50 (ASTM method D3900), an ENB mass percent of about 4.9 (ASTM method D6047), a density of about 0.86 g/cm³, and is commercially available from The Dow Chemical Company, Midland, MI, USA.

NORDEL™ IP 4770R is an EPDM having a Mooney viscosity, ML1+4 @ 125 °C, of about 70 (ASTM method D1646), an ethylene mass percent of about 70 (ASTM method D3900), an ENB mass percent of about 4.9 (ASTM method D6047), a density of about 0.88 g/cm³, and is commercially available from The Dow Chemical Company, Midland, MI, USA.

### Polar Elastomers

ELVAX™ 150W is an ethylene-vinyl acetate copolymer having a vinyl acetate comonomer content of about 32 wt%, a melting point of about 63 °C, a density of about 0.957 g/cm³, a melt index of about 43 g/10 minutes, and is commercially available from E.I. du Pont de Nemours and Company, Wilmington, DE, USA. According to product literature, the "W" in the trade name indicates that this product additionally contains a "W" amide additive to improve pellet handling.

ELVAX™ 250 is an ethylene-vinyl acetate copolymer having a vinyl acetate comonomer content of about 28 wt%, a melting point of about 70 °C, a density of about 0.951 g/cm³, a melt index of about 25 g/10 minutes, and is commercially available from E.I. du Pont de Nemours and Company, Wilmington, DE, USA.

EVATANE™ 28-800 is an ethylene-vinyl acetate copolymer having a vinyl acetate comonomer content of about 28 wt%, a melting point of about 64 °C, a density of about 0.950 g/cm³, and a melt index of about 800 g/10 minutes. EVATANE™ 28-800 is commercially available from Arkema S.A., Colombes, France.

The thermoplastic polyurethane ("TPU") employed in the following Examples is ESTANE™ MVT 70AT3, which is an aromatic polyether-based TPU having a melting point of about 135 °C and a density of about 1.060 g/cm³. ESTANE™ MVT 70AT3 is commercially available from Lubrizol Advanced Materials, Inc., Cleveland, OH, USA.

### Thermally Conductive Fillers

The aluminum nitride (AlN) employed in the following examples is available from Desunmet Ceramic Material Co. Ltd. The AlN is in the form of a powder having a density of 3.26 g/cm³, a theoretical value of thermal conductivity of 320 watts per meter Kelvin ("W/m·K"), and an average particle size of about 7 µm.

ZTP-200 is an α-Al₂O₃ having an average particle size of about 4 µm and a thermal conductivity of about 32 W/m·K. ZTP-200 is commercially available from Zhengzhou Zhongtian Special Alumina Co., Ltd.

The spherical Al₂O₃ has a particle size of about 4 µm and a thermal conductivity of about 32 W/m·K. The spherical Al₂O₃ is commercially available from Shanghai Bestry Performance Materials Co., Ltd.

### Other

The high-density polyethylene ("HDPE") employed below is HDPE 2200J having a density of about 0.964 g/cm³, a melt index of about 5.5 g/10 minutes, and is commercially available from Yanshan Petrochemical Co., Beijing, China.

### EXAMPLES

### Example 1

Prepare six Samples (S1-S6) according to the formulations provided in Table 1, below. Prepare Samples S1-S6 by first blending the filler with the polar elastomer using a laboratory-scale HAAKE mixer. Set the mixer initially at 160 °C and a rotor speed of 60 revolutions per minute ("rpm"). In each Sample, first load the polar elastomer into the mixer for complete melting, then add the filler slowly and mix for an additional 15 minutes at 60 rpm. Depending on the filler type and loading content, melt temperature may range from 170 to 175 °C at the end of the mixing cycle. Pelletize the resulting filler-containing masterbatches for subsequent use. In the second step, set the initial temperature at 180 °C for S1, 160 °C for S2, 190 °C for S3, 150 °C for S4, 180 °C for S5, and 165 °C for S6. Next, load the filler-containing masterbatch into the mixer with the non-masterbatch resin and mix for 10 minutes at 60 rpm.

After mixing, compress the resulting blends at their respective compounding temperatures using a compression molder at 10 MPa into a film of about 1 mm. Cool the film to room temperature. The resulting cooled film is used for property evaluation.

Comparative Samples CS1(a), CS1(b), CS5(a), CS5(b), CS6(a) and CS6(b): prepare blends of polar elastomer with filler and non-polar elastomer with filler, respectively, according to the formulations shown in Table 1, below. For the blends of polar elastomer with filler, the mixing temperature is initially set at 160 °C for EVA blends or 190 °C for TPU blends. For blends of non-polar elastomer and filler, the mixing temperature is initially set at 180 °C for polyolefin elastomer blends or 160 °C for EPDM blends. In each sample, first load the polymer into the mixer for complete melting, and then add the filler slowly and mix for 10 minutes at 60 rpm. The prepared blends are pressed into film of 1 mm using a compression molder at their compounding temperature and 10 MPa.

Comparative Samples CS2, CS3, and CS4: prepare phase-separated blends of polar elastomers and non-polar elastomers with homogeneously distributed filler according to the formulations shown in Table 1, below. First prepare separate masterbatches of polar elastomer plus filler and non-polar elastomer plus filler using the same procedure described above for Comparative Samples CSx(a) and CSx(b), evenly dividing the filler between the polar elastomer masterbatch and the non-polar elastomer masterbatch; then, the obtained compounds are pelletized. The pellets of the two masterbatches are loaded into the HAAKE mixer to melt at 160 °C for CS2, 190 °C for CS3 and 150 °C for CS4 for 5 minutes before further mixing. After that, a further compounding is carried out at a low rpm for a very short time.

**Table 1 - Compositions of Samples S1-S6 and CS1-CS6**

| | **POLAR ELASTOMER** | **NON-POLAR ELASTOMER** | **FILLER** |
|---|---|---|---|
| **Sample** | **ELVAX™ 250 (vol%)** | **Blended ENGAGE™* (vol%)** | **ZTP-200 (vol%)** |
| **S1** | 37.2 | 40 | 22.8 |
| **CS1(a)** | 77.2 | - | 22.8 |
| **CS1(b)** | - | 77.2 | 22.8 |
| | | | |

| **Sample** | **ELVAX™ 250 (vol%)** | **ENGAGE™ 8130 (vol%)** | **Spherical Al₂O₃ (vol%)** |
|---|---|---|---|
| **S2** | 24 | 40 | 36 |
| **CS2** | 24 | 40 | 36 |
| | | | |

| **Sample** | **TPU (vol%)** | **ENGAGE™ 8130 (vol%)** | **Spherical Al₂O₃ (vol%)** |
|---|---|---|---|
| S3 | 26 | 35 | 39 |
| **CS3** | 26 | 35 | 39 |
| | | | |

| **Sample** | **ELVAX™ 150w (vol%)** | **NORDEL™ IP 4520 (vol%)** | **ZTP-200 (vol%)** |
|---|---|---|---|
| **S4** | 36.7 | 33.3 | 30 |
| **CS4** | 36.7 | 33.3 | 30 |
| | | | |

| **Sample** | **ELVAX™ 150w (vol%)** | **ENGAGE™ 8452 (vol%)** | **AlN (vol%)** |
|---|---|---|---|
| **S5** | 23.6 | 32.5 | 43.9 |
| **CS5(a)** | 56.1 | - | 43.9 |
| **CS5(b)** | - | 56.1 | 43.9 |
| | | | |

| **Sample** | **EVATANE™ 28-800 (vol%)** | **NORDEL™ IP 4770R (vol%)** | **AlN (vol%)** |
|---|---|---|---|
| **S6** | 20.4 | 29.3 | 50.3 |
| **CS6(a)** | 49.7 | - | 50.3 |
| **CS6(b)** | - | 49.7 | 50.3 |

| | | | |
|---|---|---|---|
| *The Blended Engage is a blend of 60 vol% Engage™ 8200 and 40 vol% ENGAGE™ The Blended ENGAGE™ is prepared by HAAKE batch mixing at 100 rpm at 180 °C for 10 min. | | | |

Analyze each of Samples S1-S6 and Comparative Samples CS1-CS6 according to the test methods provided above. Results are provided in Table 2, below.

**Table 2 - Properties of Samples S1-S6 and CS1-CS6**

| **Sample** | **Thermal Conductivity (W/m·K)** | **Percent Filler in Masterbatch Phase** | **Melting Temperature (°C)** | **Volume Resistivity (Ω·cm)** | **Hardness** | |
|---|---|---|---|---|---|---|
| | | | | | **Shore A** | **Shore D** |
| **S1** | 0.690 ± 1.6E-04 | 93.5 ± 5.7 | - | 1.33 E+014 | 79.1±2.2 | 28.3±0.7 |
| **CS1(a)** | 0.657 ± 6.1E-04 | - | - | - | - | - |
| **CS1(b)** | 0.618 ± 1.1E-03 | - | - | - | - | - |
| **S2** | 0.993 ± 0.020 | 96.6 ± 1.8 | 50-85 | 4.90 E+014 | 91.0 ± 0.4 | 27.9 ± 0.5 |
| **CS2** | 0.865 ± 0.015 | - | - | - | - | - |
| **S3** | 1.140 ± 0.021 | 98.4 ± 1.5 | - | - | 68.3 ± 0.8 | 13.7 ± 0.5 |
| **CS3** | 0.995 ± 0.018 | - | - | - | - | - |
| **S4** | 0.809 ± 0.020 | 80.3 ± 8.4 | - | - | 71.5 ± 1.2 | 12.9 ± 0.5 |
| **CS4** | 0.743 ± 0.015 | - | - | - | - | - |
| **S5** | 2.410 ± 0.086 | 92.3 ± 1.8 | - | - | 96.2 ± 0.9 | 41.3 ± 1.3 |
| **CS5(a)** | 1.804 ± 0.084 | - | - | - | - | - |
| **CS5(b)** | 1.868 ± 0.052 | - | - | - | - | - |
| **S6** | 3.170 ± 0.062 | 86.7 ± 2.4 | - | - | 95.7 ± 0.8 | 39.8 ± 0.4 |
| **CS6(a)** | 2.810 ± 0.033 | - | - | - | - | - |
| **CS6(b)** | 2.009 ± 0.068 | - | - | - | - | - |

As can be seen from the results provided in Table 2, Samples S2-S4, which have the conductive filler concentrated in one of the elastomer phases, demonstrate superior thermal conductivity compared to CS2-CS4, which are prepared to have a homogeneous distribution of filler. Similarly, S1, S5 and S6 have higher thermal conductivities than their respective counterparts CS1(a), CS1(b), CS5(a), CS5(b), CS6(a), and CS6(b), which are direct blends of filler with a single elastomer.

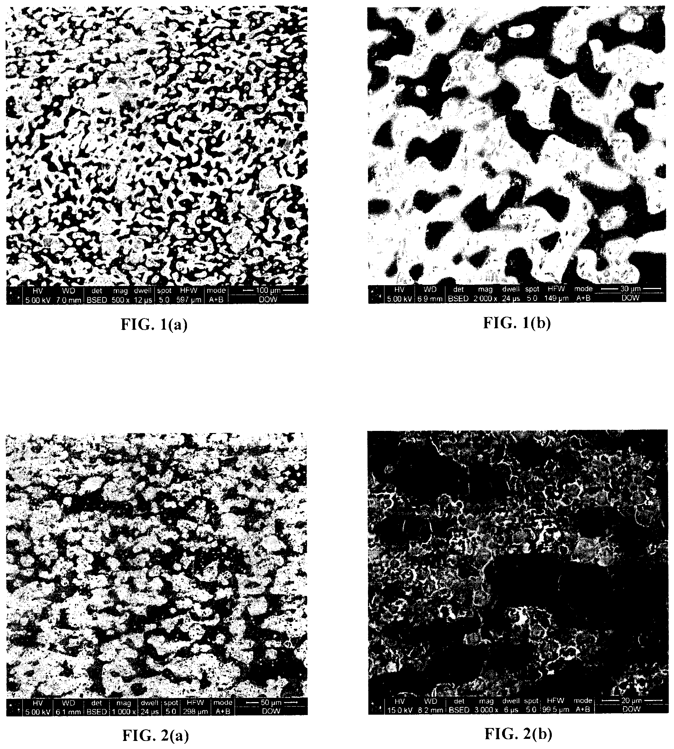

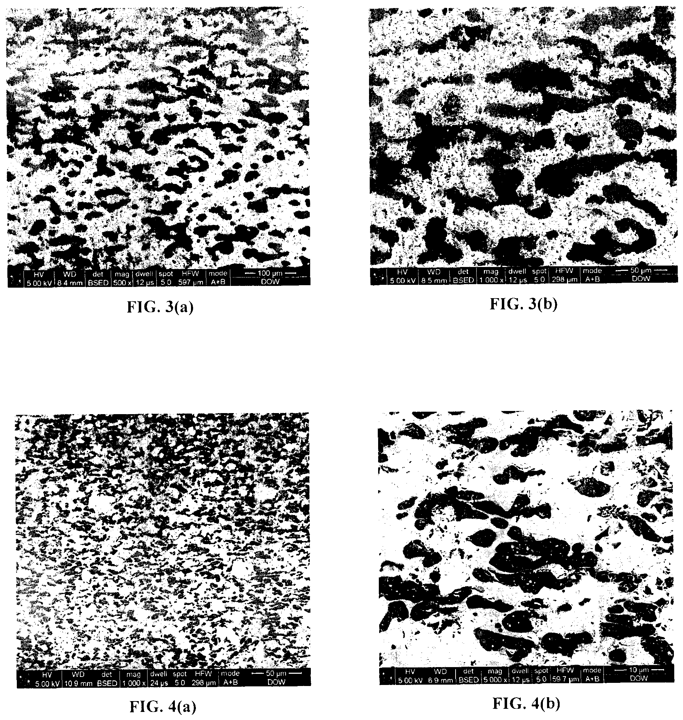

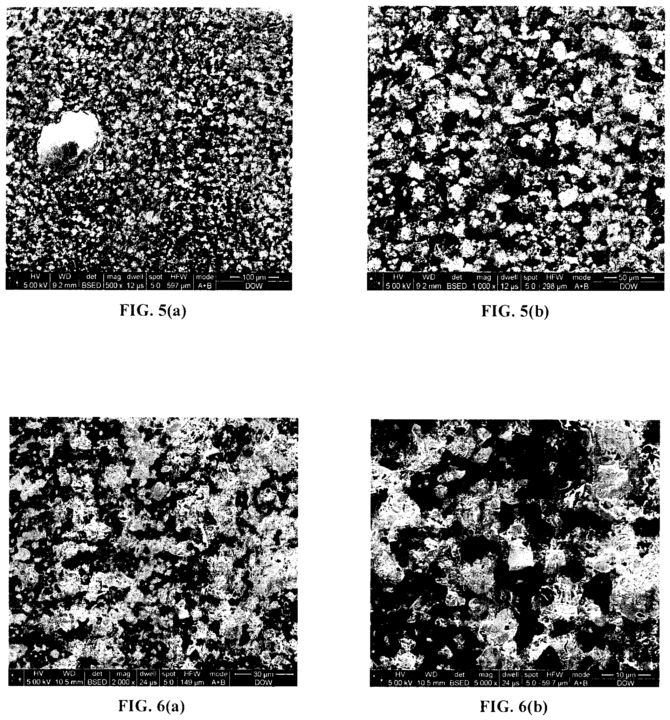

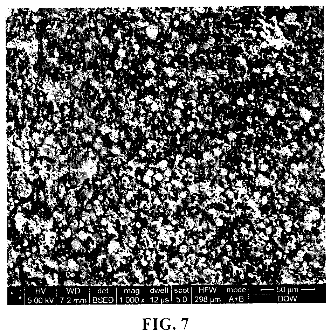

In addition to the foregoing properties, each of Samples S1-S6 and CS2 were analyzed via scanning electron microscopy. Figs. 1(a) through 6(b) illustrate high filler concentration in the polar elastomer phase (light-colored phase) versus low filler concentration in the non-polar elastomer phase (dark-colored phase). Fig. 7 provides an image of CS2 with homogeneous distribution of filler for comparison.

### Example 2

Prepare two additional Comparative Samples (CS7 and CS8). CS7 is a blend of 37.5 vol% ELVAX™ 250 with 62.5 vol% ENGAGE™ 8130 with no filler. CS8 is a blend of 37.5 vol% ELVAX™ 250 with 62.5 vol% HDPE with no filler. CS7 and CS8 are prepared by mixing the two polymer components in a HAAKE mixer for 10 minutes at 180 °C and 100 rpm. After mixing, the resulting blends are compression molded into a film of 1 mm at 180 °C and 10 MPa and then cooled to room temperature for tensile modulus analysis. Analyze CS7, CS8, S1, and S2 for tensile modulus. Results are provided in Table 3, below.

**Table 3 - Tensile Modulus Comparison**

| **Sample** | **Tensile Modulus (Automatic Young's) (MPa)** |
|---|---|
| **CS7** | 7.8 ± 0.2 |
| **CS8** | 706.9 ± 31.0 |
| **S1** | 73.6 ± 2.6 |
| **S2** | 51.8 ± 1.0 |

As shown in Table 3, when an elastomer component is replaced with a thermoplastic component such as HDPE, the tensile modulus of the resulting composition increases dramatically. Compositions having such a high tensile modulus are generally unsuitable for use as a thermal interface material.

### Example 3

Prepare three additional Samples (S7-S9) according to the formulations shown in Table 4, below. These samples are prepared in the same manner as described for Samples S1-S6 in Example 1, above.

**Table 4 - Compositions of Samples S7-S9**

| | **POLAR ELASTOMER** | **NON-POLAR ELASTOMER** | **FILLER** |
|---|---|---|---|
| **Sample** | **ELVAX™ 150w (vol%)** | **NORDEL™ IP 4770R (vol%)** | **AlN (vol%)** |
| **S7** | 24 | 31.5 | 44.5 |
| | | | |
| **Sample** | **ELVAX™ 150w (vol%)** | **NORDEL™ IP 3745 (vol%)** | **AlN (vol%)** |
| **S8** | 27 | 32.5 | 40.5 |
| | | | |
| **Sample** | **ELVAX™ 150w (vol%)** | **NORDEL™ IP 4520 (vol%)** | **ZTP-200 (vol%)** |
| **S9** | 34.4 | 37.5 | 28.1 |

It should be noted that Samples S7-S9 do not form a continuous phase of the filler-containing masterbatch in the final composition. As noted above, it is preferred that the filler-containing masterbatch form a continuous phase. In order to form a continuous phase, one needs to consider the relative viscosities and volume fractions of the two elastomer phases, which are provided in Table 5, below.

**Table 5 - Viscosities and Volume Fractions of Samples S1-S9**

| **Sample** | **Polar Elastomer Masterbatch Volume Fraction** | **Non-Polar Elastomer Volume Fraction** | **Polar Elastomer Masterbatch Viscosity (Pa·s)** | **Non-Polar Elastomer Viscosity (Pa·s)** | **Continuous Masterbatch Phase?** |
|---|---|---|---|---|---|
| **S1** | 60 | 40 | 1,130 (180 °C) | 730 (180 °C) | Yes |
| **S2** | 60 | 40 | 3,924 (177 °C) | 440 (179 °C) | Yes |
| **S3** | 65 | 35 | 679 (187 °C) | 440 (179 °C) | Yes |
| **S4** | 66.7 | 33.3 | 1,960 (150 °C) | 3,019 (150 °C) | Yes |
| **S5** | 67.5 | 32.5 | 4,833 (180 °C) | 1,175 (179 °C) | Yes |
| **S6** | 70.7 | 29.3 | 2,590 (165 °C) | 6,941 (162 °C) | Yes |
| **S7** | 68.5 | 31.5 | 7,606 (160 °C) | 6,941 (162 °C) | No |
| **S8** | 67.5 | 32.5 | 16,990 (110 °C) | 8,530 (109 °C) | No |
| **S9** | 62.5 | 37.5 | 1,960 (150 °C) | 3,019 (150 °C) | No |

To make the polar elastomer masterbatch phase become continuous, two approaches are used herein (1) increase the volume ratio of the polar elastomer filler-containing masterbatch and the non-polar elastomer, i.e. mainly increase the volume fraction of the polar elastomer filler-containing masterbatch; (2) decrease the viscosity ratio of the polar elastomer filler-containing masterbatch and the non-polar elastomer by lowering the viscosity of the polar elastomer filler-containing masterbatch and/or using non-polar elastomer resin with higher viscosity.

For the EVA/ENGAGE (TPU/ENGAGE) system S1, S2, S3, and S5, the polar elastomer filler-containing masterbatch viscosity is higher than the non-polar elastomer viscosity. The volume fraction of the filler-containing masterbatch phase is increased to 60 % or more to make the polar elastomer filler-containing masterbatch phase be continuous.

Comparing S4 with S9, it can be seen that increasing the volume fraction of the polar elastomer filler-containing masterbatch makes the filler-containing masterbatch phase become continuous. The polar elastomer filler-containing masterbatch phase of S7 is not continuous although a non-polar elastomer resin with high viscosity is used. Based on S7, the viscosity of the polar elastomer filler-containing masterbatch phase was further lowered and the volume fraction of polar elastomer filler-containing masterbatch was further increased in S6. As a result, the polar elastomer filler-containing masterbatch phase became continuous.

## Claims

1. A thermally conductive material, comprising:
(a) a non-polar elastomer;
(b) a polar elastomer; and
(c) a thermally conductive filler,
wherein said non-polar elastomer and said polar elastomer are sufficiently immiscible to be present as a multi-phase system having a non-polar elastomer phase and a polar elastomer phase, wherein said immiscibility between the non-polar elastomer and polar elastomer is observed up to a temperature of at least 200 °C,
wherein at least 60 volume percent ("vol%") of said thermally conductive filler is located in one of said non-polar elastomer phase or said polar elastomer phase,
wherein said thermally conductive material has a tensile modulus of less than 200 megapascals ("MPa").

2. The thermally conductive material of claim 1, wherein said thermally conductive material has a thermal conductivity that is at least 5 % greater than an identical material but having a homogeneously distributed thermally conductive filler.

3. The thermally conductive material of either claim 1 or claim 2, wherein at least 60 vol% of said thermally conductive filler is located in said polar elastomer phase.

4. The thermally conductive material of any one of the foregoing claims, wherein each of said non-polar elastomer and said polar elastomer is a thermoplastic elastomer; wherein each of said non-polar elastomer and said polar elastomer has a melting point of less than 90 °C; wherein said thermally conductive material has a melting point of less than 90 °C.

5. The thermally conductive material of any one of the foregoing claims, wherein said thermally conductive filler is present in said thermally conductive material in an amount ranging from 20 to 60 vol% based on the total volume of components (a) through (c); wherein said non-polar elastomer is present in said thermally conductive material in an amount ranging from 20 to 40 vol% based on the total volume of components (a) through (c); wherein said polar elastomer is present in said thermally conductive material in an amount ranging from 20 to 40 vol% based on the total volume of components (a) through (c).

6. The thermally conductive material of any one of the foregoing claims, wherein said non-polar elastomer and said polar elastomer are present in a volume ratio sufficient to achieve a viscosity ratio between said non-polar elastomer and said polar elastomer such that the elastomer phase containing at least 60 vol% of said thermally conductive filler forms a continuous phase in said thermally conductive material.

7. The thermally conductive material of any one of the foregoing claims, wherein said thermally conductive filler has a thermal conductivity ranging from 25 to 1,700 watts per meters Kelvin ("W/m·K"); wherein said thermally conductive filler has a D50 particle size distribution ranging from 0.01 to 50 micrometers ("µm"); wherein said non-polar elastomer is selected from the group consisting of polyolefin elastomers, ethylene-propylene-diene monomer ("EPDM") rubbers, styrenic block copolymers, and combinations of two or more thereof; wherein said polar elastomer is selected from the group consisting of ethylene vinyl acetate ("EVA"), polyurethane rubber, thermoplastic polyurethane ("TPU"), ethylene acrylate copolymers, ethylene acrylic acid copolymers, and combinations of two or more thereof.

8. An article of manufacture, comprising:
(a) a heat-generating component;
(b) a heat-dissipating component; and
(c) a thermal interface material,
wherein said thermal interface material is positioned so as to transfer heat from said heat-generating component to said heat-dissipating component,
wherein said thermal interface material comprises at least a portion of said thermally conductive material of any one of the foregoing claims.

9. A method for preparing a thermally conductive material, said method comprising:
(a) combining a thermally conductive filler with a first elastomer thereby forming a filler-containing masterbatch; and
(b) combining said filler-containing masterbatch with a second elastomer thereby forming said thermally conductive material,
wherein said first elastomer and said second elastomer are sufficiently immiscible to be present in said thermally conductive material as a multi-phase system having a first elastomer phase formed by at least a portion of said first elastomer and a second elastomer phase formed by at least a portion of said second elastomer, wherein said immiscibility between the non-polar elastomer and polar elastomer is observed up to a temperature of at least 200 °C,
wherein at least 60 volume percent ("vol%") of said thermally conductive filler remains located in said first elastomer phase following said combining of step (b),
wherein one of said first and second elastomers is a non-polar elastomer, wherein the other of said first and second elastomers is a polar elastomer,
wherein said thermally conductive material has a tensile modulus of less than 200 megapascals ("MPa").

10. The method of claim 9, wherein said polar elastomer is said first elastomer, wherein said thermally conductive filler is present in said thermally conductive material in an amount ranging from 20 to 60 vol% based on the total volume of components (a) through (c); wherein said non-polar elastomer is present in said thermally conductive material in an amount ranging from 20 to 40 vol% based on the total volume of components (a) through (c); wherein said polar elastomer is present in said thermally conductive material in an amount ranging from 20 to 40 vol% based on the total volume of components (a) through (c).

## Patentansprüche

1. Ein wärmeleitendes Material, beinhaltend:
(a) ein nicht polares Elastomer:
(b) ein polares Elastomer; und
(c) einen wärmeleitenden Füllstoff,
wobei das nicht polare Elastomer und das polare Elastomer ausreichend unvermischbar sind, um als ein Mehrphasensystem vorzuliegen, das eine nicht polare Elastomerphase und eine polare Elastomerphase aufweist, wobei die Unvermischbarkeit zwischen dem nicht polaren Elastomer und dem polaren Elastomer bis zu einer Temperatur von mindestens 200 °C beobachtet wird,
wobei mindestens 60 Volumenprozent ("Vol.-%") des wärmeleitenden Füllstoffs in einer von der nicht polaren Elastomerphase oder der polaren Elastomerphase vorhanden sind,
wobei das wärmeleitende Material einen Elastizitätsmodul von weniger als 200 Megapascal ("MPa") aufweist.

2. Wärmeleitendes Material gemäß Anspruch 1, wobei das wärmeleitende Material eine Wärmeleitfähigkeit aufweist, die mindestens 5 % über der eines identischen Materials, das jedoch einen homogen verteilten wärmeleitenden Füllstoff aufweist, liegt.

3. Wärmeleitendes Material gemäß entweder Anspruch 1 oder Anspruch 2, wobei mindestens 60 Vol.-% des wärmeleitenden Füllstoffs in der polaren Elastomerphase vorhanden sind.

4. Wärmeleitendes Material gemäß einem der vorhergehenden Ansprüche, wobei jedes von dem nicht polaren Elastomer und dem polaren Elastomer ein thermoplastisches Elastomer ist; wobei jedes von dem nicht polaren Elastomer und dem polaren Elastomer einen Schmelzpunkt von weniger als 90 °C aufweist; wobei das wärmeleitende Material einen Schmelzpunkt von weniger als 90 °C aufweist.

5. Wärmeleitendes Material gemäß einem der vorhergehenden Ansprüche, wobei der wärmeleitende Füllstoff in dem wärmeleitenden Material in einer Menge im Bereich von 20 bis 60 Vol.-% vorliegt, bezogen auf das Gesamtvolumen der Komponenten (a) bis (c); wobei das nicht polare Elastomer in dem wärmeleitenden Material in einer Menge im Bereich von 20 bis 40 Vol.-% vorliegt, bezogen auf das Gesamtvolumen der Komponenten (a) bis (c); wobei das polare Elastomer in dem wärmeleitenden Material in einer Menge im Bereich von 20 bis 40 Vol.-% vorliegt, bezogen auf das Gesamtvolumen der Komponenten (a) bis (c).

6. Wärmeleitendes Material gemäß einem der vorhergehenden Ansprüche, wobei das nicht polare Elastomer und das polare Elastomer in einem Volumenverhältnis vorliegen, das ausreicht, um ein Viskositätsverhältnis zwischen dem nicht polaren Elastomer und dem polaren Elastomer zu erreichen, sodass die Elastomerphase, die mindestens 60 Vol.-% des wärmeleitenden Füllstoffs enthält, eine kontinuierliche Phase in dem wärmeleitenden Material bildet.

7. Wärmeleitendes Material gemäß einem der vorhergehenden Ansprüche, wobei der wärmeleitende Füllstoff eine Wärmeleitfähigkeit im Bereich von 25 bis 1700 Watt pro Meter und Kelvin ("W/m·K") aufweist; wobei der wärmeleitende Füllstoff eine D50-Partikelgrößenverteilung im Bereich von 0,01 bis 50 Mikrometer ("µm") aufweist; wobei das nicht polare Elastomer aus der Gruppe ausgewählt ist, die aus Polyolefinelastomeren, Ethylen-Propylen-Dien-Monomer-Kautschuken ("EPDM-Kautschuken"), Styrolblockcopolymeren und Kombinationen von zwei oder mehreren davon besteht; wobei das polare Elastomer aus der Gruppe ausgewählt ist, die aus Ethylenvinylacetat ("EVA"), Polyurethankautschuk, thermoplastischem Polyurethan ("TPU"), Ethylen-Acrylat-Copolymeren, Ethylen-Acrylsäure-Copolymeren und Kombinationen von zwei oder mehreren davon besteht.

8. Ein Herstellungsartikel, beinhaltend:
(a) eine wärmeerzeugende Komponente;
(b) eine wärmeableitende Komponente; und
(c) ein Wärmeleitmaterial,
wobei das Wärmeleitmaterial so positioniert ist, dass es Wärme von der wärmeerzeugenden Komponente zu der wärmeableitenden Komponente transferiert, wobei das Wärmeleitmaterial mindestens einen Teil des wärmeleitenden Materials gemäß einem beliebigen der vorhergehenden Ansprüche beinhaltet.

9. Ein Verfahren zum Zubereiten eines wärmeleitenden Materials, wobei das Verfahren Folgendes beinhaltet:
(a) Kombinieren eines wärmeleitenden Füllstoffs mit einem ersten Elastomer, wodurch ein Füllstoff enthaltender Masterbatch gebildet wird; und
(b) Kombinieren des Füllstoff enthaltenden Masterbatches mit einem zweiten Elastomer, wodurch das wärmeleitende Material gebildet wird,
wobei das erste Elastomer und das zweite Elastomer ausreichend unvermischbar sind, um in dem wärmeleitenden Material als ein Mehrphasensystem vorzuliegen, das eine erste Elastomerphase, die aus mindestens einem Teil des ersten Elastomers gebildet wird, und eine zweite Elastomerphase, die aus mindestens einem Teil des zweiten Elastomers gebildet wird, aufweist, wobei die Unvermischbarkeit zwischen dem nicht polaren Elastomer und dem polaren Elastomer bis zu einer Temperatur von mindestens 200 °C beobachtet wird,
wobei nach dem Kombinieren in Schritt (b) mindestens 60 Volumenprozent ("Vol.-%") des wärmeleitenden Füllstoffs in der ersten Elastomerphase verbleiben,
wobei eines von dem ersten und dem zweiten Elastomer ein nicht polares Elastomer ist, wobei das andere von dem ersten und dem zweiten Elastomer ein polares Elastomer ist,
wobei das wärmeleitende Material einen Elastizitätsmodul von weniger als 200 Megapascal ("MPa") aufweist.

10. Verfahren gemäß Anspruch 9, wobei das polare Elastomer das erste Elastomer ist, wobei der wärmeleitende Füllstoff in dem wärmeleitenden Material in einer Menge im Bereich von 20 bis 60 Vol.-% vorliegt, bezogen auf das Gesamtvolumen der Komponenten (a) bis (c); wobei das nicht polare Elastomer in dem wärmeleitenden Material in einer Menge im Bereich von 20 bis 40 Vol.-% vorliegt, bezogen auf das Gesamtvolumen der Komponenten (a) bis (c); wobei das polare Elastomer in dem wärmeleitenden Material in einer Menge im Bereich von 20 bis 40 Vol.-% vorliegt, bezogen auf das Gesamtvolumen der Komponenten (a) bis (c).

## Revendications

1. Un matériau thermoconducteur, comprenant :
(a) un élastomère non polaire ;
(b) un élastomère polaire ; et
(c) une charge thermoconductrice,
dans lequel ledit élastomère non polaire et ledit élastomère polaire sont suffisamment non miscibles pour être présents sous la forme d'un système multiphasique ayant une phase élastomère non polaire et une phase élastomère polaire, dans lequel ladite non-miscibilité entre l'élastomère non polaire et l'élastomère polaire est observée jusqu'à une température d'au moins 200 °C,
dans lequel au moins 60 pour cent en volume (« % en volume ») de ladite charge thermoconductrice est située dans une phase parmi ladite phase élastomère non polaire ou ladite phase élastomère polaire,
ledit matériau thermoconducteur ayant un module en traction de moins de 200 mégapascals (« MPa »).

2. Le matériau thermoconducteur de la revendication 1, ledit matériau thermoconducteur ayant une conductivité thermique qui est supérieure d'au moins 5 % à un matériau identique mais ayant une charge thermoconductrice répartie de façon homogène.

3. Le matériau thermoconducteur soit de la revendication 1, soit de la revendication 2, dans lequel au moins 60 % en volume de ladite charge thermoconductrice est située dans ladite phase élastomère polaire.

4. Le matériau thermoconducteur de n'importe laquelle des revendications mentionnées ci-dessus, dans lequel chaque élastomère parmi ledit élastomère non polaire et ledit élastomère polaire est un élastomère thermoplastique ; dans lequel chaque élastomère parmi ledit élastomère non polaire et ledit élastomère polaire a un point de fusion de moins de 90 °C ; ledit matériau thermoconducteur ayant un point de fusion de moins de 90 °C.

5. Le matériau thermoconducteur de n'importe laquelle des revendications mentionnées ci-dessus, dans lequel ladite charge thermoconductrice est présente dans ledit matériau thermoconducteur dans une quantité comprise dans la gamme allant de 20 à 60 % en volume rapporté au volume total des constituants (a) à (c) ; dans lequel ledit élastomère non polaire est présent dans ledit matériau thermoconducteur dans une quantité comprise dans la gamme allant de 20 à 40 % en volume rapporté au volume total des constituants (a) à (c) ; dans lequel ledit élastomère polaire est présent dans ledit matériau thermoconducteur dans une quantité comprise dans la gamme allant de 20 à 40 % en volume rapporté au volume total des constituants (a) à (c).

6. Le matériau thermoconducteur de n'importe laquelle des revendications mentionnées ci-dessus, dans lequel ledit élastomère non polaire et ledit élastomère polaire sont présents dans un rapport en volume suffisant pour obtenir un rapport de viscosité entre ledit élastomère non polaire et ledit élastomère polaire de telle sorte que la phase élastomère contenant au moins 60 % en volume de ladite charge thermoconductrice forme une phase continue dans ledit matériau thermoconducteur.

7. Le matériau thermoconducteur de n'importe laquelle des revendications mentionnées ci-dessus, dans lequel ladite charge thermoconductrice a une conductivité thermique comprise dans la gamme allant de 25 à 1 700 watts par mètre-kelvin (« W/m·K ») ; dans lequel ladite charge thermoconductrice a une répartition granulométrique D50 comprise dans la gamme allant de 0,01 à 50 micromètres (« µm ») ; dans lequel ledit élastomère non polaire est sélectionné dans le groupe constitué d'élastomères de polyoléfine, de caoutchoucs de monomères d'éthylène-propylène-diène (« EPDM »), de copolymères blocs styréniques, et de combinaisons de deux de ceux-ci ou plus ; dans lequel ledit élastomère polaire est sélectionné dans le groupe constitué de l'éthylène-acétate de vinyle (« EVA »), du caoutchouc de polyuréthane, du polyuréthane thermoplastique (« TPU »), de copolymères d'éthylène/acrylate, de copolymères d'éthylène/acide acrylique, et de combinaisons de deux de ceux-ci ou plus.

8. Un article manufacturé, comprenant :
(a) un constituant calogène ;
(b) un constituant dissipateur de chaleur ; et
(c) un matériau d'interface thermique,
dans lequel ledit matériau d'interface thermique est positionné de façon à transférer de la chaleur dudit constituant calogène audit constituant dissipateur de chaleur,
dans lequel ledit matériau d'interface thermique comprend au moins une portion dudit matériau thermoconducteur de n'importe laquelle des revendications mentionnées ci-dessus.

9. Une méthode pour la préparation d'un matériau thermoconducteur, ladite méthode comprenant :
(a) la combinaison d'une charge thermoconductrice avec un premier élastomère, formant de cette façon un mélange maître contenant une charge ; et
(b) la combinaison dudit mélange maître contenant une charge avec un deuxième élastomère, formant de cette façon ledit matériau thermoconducteur,
dans laquelle ledit premier élastomère et ledit deuxième élastomère sont suffisamment non miscibles pour être présents dans ledit matériau thermoconducteur sous la forme d'un système multiphasique ayant une première phase élastomère formée par au moins une portion dudit premier élastomère et une deuxième phase élastomère formée par au moins une portion dudit deuxième élastomère, dans laquelle ladite non-miscibilité entre l'élastomère non polaire et l'élastomère polaire est observée jusqu'à une température d'au moins 200 °C,
dans laquelle au moins 60 pour cent en volume (« % en volume ») de ladite charge thermoconductrice reste située dans ladite première phase élastomère à la suite de ladite combinaison de l'étape (b),
dans laquelle un élastomère parmi lesdits premier et deuxième élastomères est un élastomère non polaire, dans laquelle l'autre élastomère parmi lesdits premier et deuxième élastomères est un élastomère polaire,
dans laquelle ledit matériau thermoconducteur a un module en traction de moins de 200 mégapascals (« MPa »).

10. La méthode de la revendication 9, dans laquelle ledit élastomère polaire est ledit premier élastomère, dans laquelle ladite charge thermoconductrice est présente dans ledit matériau thermoconducteur dans une quantité comprise dans la gamme allant de 20 à 60 % en volume rapporté au volume total des constituants (a) à (c) ; dans laquelle ledit élastomère non polaire est présent dans ledit matériau thermoconducteur dans une quantité comprise dans la gamme allant de 20 à 40 % en volume rapporté au volume total des constituants (a) à (c) ; dans laquelle ledit élastomère polaire est présent dans ledit matériau thermoconducteur dans une quantité comprise dans la gamme allant de 20 à 40 % en volume rapporté au volume total des constituants (a) à (c).
